# DEMANDE DE BREVET EUROPEEN

(11) **EP 1 339 144 A1**
(43) Date de publication de la demande: **27.08.2003**
(21) Numéro de dépôt: 02293002.8
(22) Date de dépôt: 05.12.2002
(51) Int. Cl.: H01S 5/22

(54) **Composant optique semi-conducteur**

(30) Priorité: 06.12.2001 FR 0115775
(71) Demandeur: ALCATEL, 75008 Paris (FR)
(72) Inventeur: Lovisa, Stéphane, 75014 Paris (FR)
(74) Mandataire: Fournier, Michel

(57) **Abrégé**

Le composant optique semi-conducteur de type laser comprend :
- un substrat (1) en un matériau semi-conducteur
- une couche de revêtement dite inférieure (2) contenant des porteurs de type n
- une couche active (4) formant au moins un puits quantique
- une couche de revêtement dite supérieure (6) contenant des porteurs de type p.

Pour pouvoir augmenter la puissance d'émission du laser sans augmenter la divergence verticale du faisceau, la couche de revêtement inférieure (2) a un indice de réfraction plus élevé que celui de la couche de revêtement supérieure (6).
Application aux lasers de pompage des amplificateurs optiques à fibre.

## Description

La présente invention concerne un composant optique semi-conducteur comprenant un empilement de couches, et plus particulièrement un laser à semi-conducteur.

De manière connue, un laser à semi-conducteur peut être utilisé en tant que source de pompage pour l'amplification de signaux optiques transportés sur de longues distances par une fibre optique.

Un laser à semi-conducteur est un composant optique comprenant généralement un empilement de couches semi-conductrices dopées ou non et en particulier une couche dite active. Alimentée en courant, cette couche active émet des rayonnements par électro-luminescence. A partir d'un seuil de courant, les rayonnements émis par la couche active peuvent être amplifiés et correspondent alors à des rayonnements lasers de longueurs d'onde par exemple comprises dans une bande située autour de 980 nm dans le cas de certains lasers de pompage optique. Le laser, généralement de forme parallélépipédique, peut posséder des faces latérales avant et arrière clivées pour former des miroirs facettés afin que s'établissent dans le laser des modes de propagation longitudinaux de type Fabry-Pérot.

Dans tout ce qui suit, le terme « couche » peut désigner une couche unique ou une superposition de couches remplissant la même fonction.

Plus précisément, ce type de lasers comprend classiquement un substrat à base d'arséniure de gallium (GaAs) dopé n sur lequel sont déposées successivement :
- une couche de revêtement inférieure en AlGaAs dopé n,
- une couche de confinement inférieure en InGaAsP,
- une couche active en InGaAsP formant au moins un puits quantique
- une couche de confinement supérieure en InGaAsP,
- une couche de revêtement supérieure en AlGaAs dopé p,
- une ou plusieurs couches de contact, généralement en GaAs, servant à la prise de contact ohmique, c'est-à-dire à la bonne circulation du courant injecté vers la couche active.

Les couches de confinement sont également appelées couches SCH pour "Separate Confinement Heterostructure" en anglais.

Les couches active et de confinement forment la zone optiquement active du laser, également dénommée guide optique.

On cherche actuellement à accroître la puissance couplée à partir d'un tel laser à l'intérieur de la fibre optique à laquelle il est raccordé, et ce à courant injecté constant.

Pour ce faire, il est connu d'utiliser un laser dit « Broad Waveguide » (BW), dont les couches de confinement inférieure et supérieure sont beaucoup plus épaisses que dans les lasers classiques. Typiquement, l'épaisseur des couches de confinement dans un laser BW est de l'ordre de 600 nm, contre 100 nm pour un laser classique. Ceci a pour effet de confiner pratiquement tout le mode (typiquement 99%) dans la couche active, et donc d'augmenter le rendement externe du laser.

Toutefois, l'augmentation de l'épaisseur des couches de confinement entraîne un élargissement important du guide optique. De ce fait, la divergence verticale du laser augmente sensiblement. Ceci résulte du fait que le mode est très « pincé » dans la couche active, ce qui entraîne une forte divergence dès la sortie du laser. On rappelle que la divergence verticale est l'angle au sommet du cône de sortie du faisceau laser dans un plan perpendiculaire au plan des couches semi-conductrices. Typiquement, la divergence verticale est de l'ordre de 32°.

Pour résoudre ce problème, il est connu de placer en sortie du laser, avant la fibre, un dispositif, tel qu'une lentille, destiné à rétrécir verticalement le faisceau laser.

Cependant, cette solution n'est pas satisfaisante, car le taux de couplage obtenu n'est absolument pas reproductible, de sorte qu'elle n'est pas envisageable industriellement.

La présente invention a donc pour but de mettre au point un composant optique semi-conducteur du type laser à semi-conducteur dont le rendement externe soit comparable à celui des lasers les plus puissants connus à l'heure actuelle et dont la divergence soit réduite par rapport à l'art antérieur.

La présente invention propose à cet effet un composant optique semi-conducteur du type laser à semi-conducteur comprenant :
- un substrat en un matériau semi-conducteur
- une couche de revêtement dite inférieure contenant des porteurs de type n
- une couche active formant au moins un puits quantique
- une couche de revêtement dite supérieure contenant des porteurs de type p
**caractérisé en ce que** ladite couche de revêtement inférieure a un indice de réfraction plus élevé que celui de ladite couche de revêtement supérieure.

Selon l'invention, on rend le mode propre de propagation de la lumière dans le composant asymétrique par rapport au puits quantique en choisissant un indice de réfraction de la couche de revêtement inférieure supérieur à celui de la couche de revêtement supérieure. L'idée à la base de l'invention est d'abord de pouvoir étaler verticalement le mode afin qu'il soit moins « pincé » et donc moins divergent. Mais un simple étalement dans une structure classique ne conviendrait pas car le mode couvrirait de manière trop importante les zones contenant les porteurs n et p, ces porteurs créant des pertes additionnelles par absorption de la lumière. Or les porteurs de type p sont plus absorbants que les porteurs de type n. L'idée est donc d' « attirer » le mode vers la couche de revêtement contenant les porteurs de type n pour l'éloigner de celle contenant les porteurs de type p. Ceci est obtenu en choisissant un indice de réfraction de la couche de revêtement inférieure plus élevé que celui de la couche de revêtement supérieure.

L'invention permet de réduire la divergence verticale. On obtient des divergences verticales de l'ordre de 23° au lieu de 32° dans l'art antérieur. De ce fait, la reproductibilité du couplage par l'intermédiaire d'une lentille entre un composant selon l'invention et une fibre optique est nettement accrue. Typiquement, on peut ainsi obtenir dans 95% des cas un taux de couplage supérieur à 65%, alors qu'avec le composant de l'art antérieur, un taux de couplage supérieur à 55% n'était obtenu que dans 50 à 80% des cas.

La différence d'indice entre la couche de revêtement inférieure et la couche de revêtement supérieure est avantageusement au moins égale à 0,01.

Avantageusement, lorsque les couches de revêtement inférieure et supérieure sont en un alliage à base d'AIGaAs, la différence d'indice est obtenue en choisissant une concentration molaire en aluminium dans la couche de revêtement inférieure moins élevée que la concentration molaire en aluminium dans la couche de revêtement supérieure.

Selon un mode de réalisation préférentiel, la différence entre ces concentrations molaires est au moins égale à 2%.

Selon un autre mode de réalisation avantageux, la différence est au moins égale à 5% et une couche réfléchissante est disposée entre le substrat et la couche de revêtement inférieure. Cette couche réfléchissante est rendue nécessaire car la différence d'indice entre le substrat et la couche de revêtement inférieure est très élevée, et le mode est « aspiré » par le substrat d'indice encore plus élevé (de l'ordre de 3,52). Cette couche d'indice faible est donc insérée pour isoler optiquement le guide optique du substrat.

Par exemple, on peut choisir une concentration molaire en aluminium de 45% dans la couche de revêtement supérieure, et de 38% dans la couche de revêtement inférieure.

Lorsque le composant optique comprend en outre une couche dite de confinement inférieure entre la couche de revêtement inférieure et la couche active, et une couche dite de confinement supérieure entre la couche active et la couche de revêtement supérieure, l'épaisseur de ces deux couches de confinement est de préférence choisie supérieure à 140 nm.

De la sorte, on modifie la configuration de la zone de confinement pour compenser l'étalement du mode en augmentant son confinement, ce qui permet de conserver un rendement interne du composant suffisant. Le recouvrement entre le puits quantique et le mode reste ainsi sensiblement le même.

Le composant optique selon l'invention a donc alors un rendement interne équivalent à celui des composants de l'art antérieur, et un rendement externe nettement amélioré du fait de la diminution de la divergence verticale.

L'invention porte également sur un laser comprenant un composant optique tel que défini ci-dessus.

D'autres caractéristiques et avantages de la présente invention apparaîtront dans la description suivante d'un mode de réalisation de l'invention, donnée à titre illustratif et nullement limitatif.

Dans les figures suivantes :
- la figure 1 représente de manière très schématique en coupe un laser semi-conducteur selon l'invention
- la figure 2 représente le profil du mode propre d'un laser à profil d'indice symétrique de l'art antérieur
- la figure 3 représente le profil du mode propre d'un laser à profil d'indice asymétrique selon l'invention.

Dans toutes ces figures, les éléments communs portent les mêmes numéros de référence.

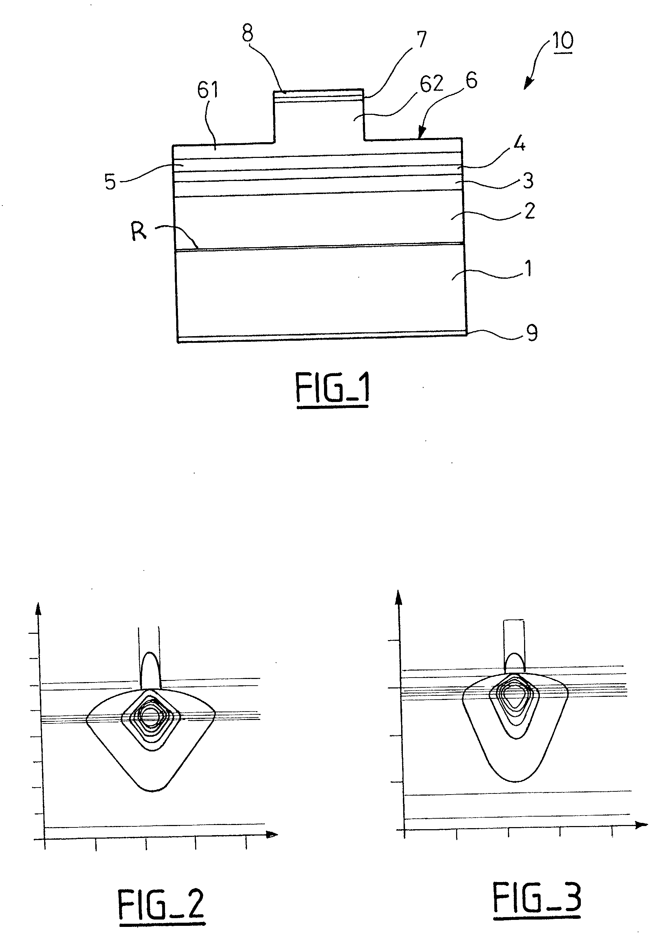

On a représenté de manière très schématique en figure 1 une coupe transversale d'un laser ruban à semi-conducteur 10 selon l'invention.

Le laser 10 comprend un substrat 1 en arséniure de gallium GaAs contenant des porteurs de type n sur lequel sont déposées successivement par exemple par épitaxie de type MOVPE (Metal Organic Vapor Phase Epitaxy) :
- une couche de revêtement inférieure 2 en alliage Al_{0,38}Ga_{0,62}As contenant des porteurs de type n, d'indice de réfraction égal à 3,317 et d'épaisseur environ égale à 2 µm,
- une couche de confinement inférieure 3 par exemple en AlₓGa₁₋ₓAs, d'épaisseur environ égale à 0,14 µm et d'indice de réfraction continûment variable,
- une couche active formant puits quantique 4 par exemple en InₓGa₁₋ₓAs, d'indice de réfraction égal à 3,6 et d'épaisseur environ égale à 0,007 µm,
- une couche de confinement supérieure 5 par exemple en AlₓGa₁₋ₓAs, d'épaisseur environ égale à 0,14 µm et d'indice de réfraction continûment variable,
- une couche de revêtement supérieure 6 en alliage Al_{0,45}Ga_{0,55}As contenant des porteurs de type p, d'indice de réfraction égal à 3,28 et d'épaisseur environ égale à 1,7 µm
- une couche de contact 7,
- une couche électrode 8 contenant des porteurs de type p.

Une couche électrode 9 contenant des porteurs de type n est en outre déposée sur le substrat 1 sur la face de ce dernier opposée à celle sur laquelle sont déposées les couches 2 à 8. Les couches électrodes 8 et 9 sont reliées à une alimentation en courant (non représentée).

De manière connue, la couche de revêtement supérieure 6 est formée de deux zones :
- une zone 61 en contact avec la couche de confinement supérieure 5 et occupant toute la largeur du laser 10,
- une zone 62 située au-dessus de la zone 61 et obtenue par gravure éliminant partiellement la matière de la couche 6 excepté sur une zone centrale de largeur inférieure à celle du laser 10 ; c'est cette zone 62 qui est appelée ruban.

Le choix des alliages constituant la couche active 4 et les couches de confinement 3 et 5 ainsi que le choix de leurs épaisseurs sont donnés à titre indicatif.

Selon l'invention, les alliages formant les couches de revêtement inférieure 2 et supérieure 6 sont différents par leur concentration en aluminium (45 mol% pour la couche 6 et 38 mol% pour la couche 2), de sorte que l'indice de réfraction de la couche 2 est supérieur à celui de la couche 6.

On a illustré en figure 2 le profil du mode propre d'un laser à profil d'indice symétrique de l'art antérieur, et en figure 3 celui d'un laser asymétrique selon l'invention. Le plan de ces figures correspond à la coupe transversale des lasers identique à celle de la figure 1.

La comparaison de ces deux figures montre que le mode est décalé vers le bas et que sa divergence verticale est nettement réduite.

Outre les avantages déjà mentionnés que procure l'invention, à savoir l'asymétrie du mode propre qui permet de diminuer la divergence verticale, l'invention permet en outre d'obtenir les avantages suivants.

Lorsque la concentration molaire en aluminium dans l'alliage AlGaAs est inférieure à 40%, la mobilité des électrons est fortement augmentée dans cet alliage. Ceci permet de réduire la résistance série de la couche de revêtement inférieure 2.

Par ailleurs, étant donné que le mode propre est « décalé » vers le bas dans le laser 10 selon l'invention par rapport à l'art antérieur, il est préférable de réduire l'épaisseur de la zone 61 par rapport à l'art antérieur (typiquement de 475 nm à environ 200 nm). De ce fait, lors de l'injection de courant, la zone de gain est beaucoup plus étroite et a sensiblement la même largeur que le mode optique, alors que dans l'art antérieur, la zone de gain est environ deux fois plus large que le mode optique. Du fait de cette meilleure adéquation entre la zone de gain et le mode optique, le rendement électrique du laser selon l'invention est amélioré, et le courant de seuil peut ainsi être divisé par deux (8 mA contre 16 mA dans l'art antérieur).

Selon un mode de réalisation spécifique de l'invention, lorsque la concentration en aluminium dans la couche de revêtement inférieure est en-deçà de 40%, il est préférable d'interposer une couche réfléchissante (R), en AlGaAs notamment, d'épaisseur d'environ 0,2 µm par exemple, entre le substrat 1 et la couche de revêtement inférieure 2. La couche réfléchissante a par exemple un indice de réfraction de 3,22 L'utilisation de la couche réfléchissante permet d'isoler optiquement du substrat les couches épitaxiées portant le mode optique. Ceci est nécessaire dans la mesure où l'indice de réfraction du substrat est très élevé (3,52), ce qui lui permet éventuellement de « pomper » le mode optique. Pour éviter cela, insérer une couche d'indice faible revient à « éloigner » le substrat.

Bien entendu, la présente invention n'est pas limitée au mode de réalisation qui vient d'être décrit.

En particulier, les compositions, épaisseurs et indices de réfraction ont été donnés à titre d'exemple et peuvent être adaptés en fonction de l'application sans sortir du cadre de la présente invention.

Enfin, on pourra remplacer tout moyen par un moyen équivalent sans sortir du cadre de l'invention.

## Revendications

1. Composant optique semi-conducteur du type laser à semi-conducteur comprenant :
• un substrat (1) en un matériau semi-conducteur
• une couche de revêtement dite inférieure (2) contenant des porteurs de type n
• une couche active (4) formant au moins un puits quantique
• une couche de revêtement dite supérieure (6) contenant des porteurs de type p,
**caractérisé en ce que** ladite couche de revêtement inférieure (2) a un indice de réfraction plus élevé que celui de ladite couche de revêtement supérieure (6).

2. Composant selon la revendication 1, **caractérisé en ce que** la différence entre l'indice de réfraction de ladite couche de revêtement inférieure (2) et celle de ladite couche de revêtement supérieure (6) est au moins égale à 0,01.

3. Composant selon la revendication 1, **caractérisé en ce que** lesdites couches de revêtement inférieure et supérieure (2, 6) sont en un alliage à base d'AIGaAs.

4. Composant selon la revendication 3, **caractérisé en ce que** la concentration molaire en aluminium dans ladite couche de revêtement inférieure (2) est inférieure à la concentration molaire en aluminium dans ladite couche de revêtement supérieure (6).

5. Composant selon la revendication 4, **caractérisé en ce que** la différence entre lesdites concentrations molaires est au moins égale à 2%.

6. Composant selon la revendication 5, **caractérisé en ce que** ladite différence entre lesdites concentrations molaires est au moins égale à 5% et **en ce qu'**une couche réfléchissante (R) est disposée entre ledit substrat (1) et ladite couche de revêtement inférieure (2).

7. Composant selon la revendication 6, **caractérisé en ce que** la concentration molaire en aluminium est de 45% dans ladite couche de revêtement supérieure (6), et de 38% dans ladite couche de revêtement inférieure (2).

8. Composant selon l'une des revendications 1 à 7, **caractérisé en ce qu'**il comprend en outre une couche dite de confinement inférieure (3) entre ladite couche de revêtement inférieure (2) et ladite couche active (4), et une couche dite de confinement supérieure (5) entre ladite couche active (4) et ladite couche de revêtement supérieure (6).

9. Composant selon la revendication 8, **caractérisé en ce que** l'épaisseur desdites couches de confinement (3, 5) est supérieure à 140 nm.

10. Composant selon la revendication 8, **caractérisé en ce qu'**il comporte une zone ruban (62).
